# EUROPEAN PATENT APPLICATION

(11) **EP 2 216 380 A1**
(43) Date of publication of application: **11.08.2010**
(21) Application number: 08849429.9
(22) Date of filing: 14.11.2008
(51) Int. Cl.: C09D 201/00, B05D 1/30, H01L 51/50, H05B 33/10

(54) **COATING LIQUID USED IN COATING METHOD FOR DISCHARGING COATING LIQUID THROUGH SLIT-SHAPED DISCHARGE OUTLET**

(30) Priority: 16.11.2007 JP 2007297728
(71) Applicant: Sumitomo Chemical Company, Limited, Tokyo 104-8260 (JP)
(72) Inventor: MATSUE, Teruyuki, Ibaraki-shi Osaka 567-0841 (JP); KAIHO, Akio, Tsukuba-shi Ibaraki 305-0821 (JP)
(74) Representative: Duckworth, Timothy John
(86) International application number: PCT/JP2008/071162
(87) International publication number: WO 2009/064026

(57) **Abstract**

A coating solution for an application method in which a coating solution is discharged through a slit discharge port includes an organic compound that is a solid at 20°C, a first solvent having a boiling point of lower than 170°C and a second solvent having a boiling point of 170°C or higher.

## Description

### Technical Field

The present invention relates to a coating solution for use in an application method in which a coating solution is discharged through a slit discharge port.

### Background Art

As a method of forming a thin film such as a luminescent layer constituting an organic electroluminescence device (hereinafter, also abbreviated as an "organic EL device"), an application method in which a coating solution is discharged through a slit discharge port, such as a capillary coating method is known. As a coating solution used in this application method, a coating solution containing an organic compound which is a material for a thin film, and a solvent having a boiling point of lower than 170°C such as acetone, methylethylketone, methylisobutylketone, cyclohexanone, methanol, ethanol, isopropyl alcohol, ethyl acetate, butyl acetate, toluene, xylene, chloroform or water is known (see, for example, Japanese Unexamined Patent Publication No. 2004-164873).

### Disclosure of the Invention

However, when a thin film is formed according to the above application method using the above coating solution, flatness of the obtained thin film is not necessary sufficient.

An object of the present invention is to provide a coating solution for an application method in which a coating solution is discharged through a slit discharge port, which is capable of making flatness of a thin film sufficiently high in formation of the thin film.

That is, the present invention provides a coating solution, a coating method, a method of producing an organic EL device, and an organic EL device as will be described below.
[1] A coating solution for an application method comprising discharging a coating solutionthrough a slit discharge port, the coating solution comprising an organic compound that is a solid at 20°C, a first solvent having a boiling point of lower than 170°C, and a second solvent having a boiling point of 170°C or higher.
[2] The coating solution according to item [1], wherein the slit discharge port is an approximate rectangle in shape, and the width in the shorter side direction of the approximate rectangle is 0.01 to 10 mm.
[3] The coating solution according to item [1] or [2] which is a coating solution for capillary coating.
[4] The coating solution according to any one of items [1] to [3], wherein the organic compound is an organic compound for use in an organic electroluminescence device.
[5] The coating solution according to any one of items [1] to [4], wherein the weight of the second solvent is 0.5 to 99% by weight relative to the total weight of the coating solution.
[6] The coating solution according to item [5], wherein the weight of the second solvent is 0.5 to 30% by weight relative to the total weight of the coating solution.
[7] The coating solution according to any one of items [1] to [6], wherein the first solvent is an aromatic compound.
[8] The coating solution according to item [7], wherein the first solvent is xylene, anisole or mesitylene.
[9] The coating solution according to any one of items [1] to [8], wherein the second solvent is an aromatic compound.
[10] The coating solution according to item [9], wherein the second solvent is cyclohexylbenzene or tetralin.
[11] The coating solution according to any one of items [1] to [10], wherein the weight of the organic compound is 0.01 to 10% by weight relative to the total weight of the coating solution.
[12] The coating solution according to any one of items [1] to [11]having a viscosity of 1 to 20 mPa·s.
[13] The coating solution according to any one of items [1] to [12]having a surface tension of 10 to 70 mN/m.
[14] A coating method comprising applying the coating solution according to any one of items [1] to [13] by an application method comprising discharging the coating solution through a slit discharge port.
[15] A method for producing an organic electroluminescence device,the method including the step of applying the coating solution according to any one of items [1] to [13] by an application method comprising discharging the coating solution through a slit discharge port.
[16] A method for producing an organic electroluminescence device ,the method comprising the steps of: applying the coating solution according to any one of items [1] to [13] by an application method comprising discharging the coating solution through a slit discharge port to form a first thin film, and applying a coating solution to the first thin film by an application method comprising discharging the coating solution through a slit discharge port to form a second thin film.
[17] The production method according to item [16], wherein the coating solution to be used in the step of forming the first thin film and the coating solution to be used in the step of forming the second thin film are different from each other.
[18] An organic electroluminescence device produced by the production method according to any one of items [15] to [17].

### Brief Description of the Drawings

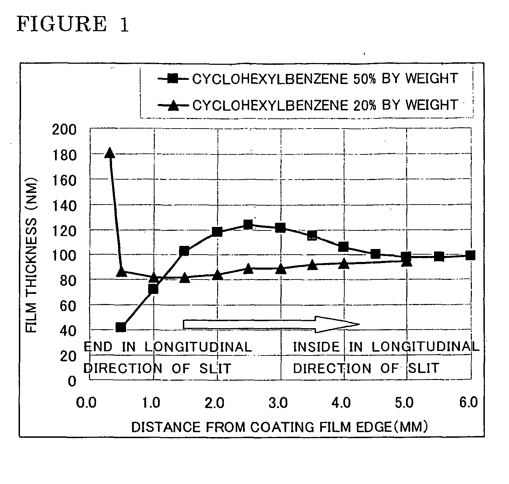

Fig. 1 is a graph showing the film thickness distribution of a thin film formed by using a coating solution for capillary coating 3 and a thin film formed by using a coating solution for capillary coating 4.

### Mode for Carrying Out the Invention

### <Coating solution for application method comprising discharging coating solution through slit discharge port>

A coating solution of the present invention for an application method comprising discharging a coating solution through a slit discharge port (hereinafter, also abbreviated as a coating solution of the present invention) contains an organic compound that is a solid at 20°C, a first solvent having a boiling point of lower than 170°C, and a second solvent having a boiling point of 170°C or higher. The organic compound contained in the coating solution of the present invention may be one kind or two or more kinds. The first solvent contained in the coating solution of the present invention may be one kind or two or more kinds, and the second solvent contained in the coating solution of the present invention may be one kind or two or more kinds.

As an application method comprising discaharging a coating solution through a slit discharge port, a capillary coat method in which a coating solution is discharged utilizing a capillary phenomenon, an application method in which a coating solution is discharged by extrusion utilizing static pressure or liquid level difference, an application method in which a coating solution is discharged by using a pump, and an application method combining any of these are recited, and a capillary coat method is preferred. As a shape of the slit discharge port, an approximate rectangle , a trapezoidal shape and the like are recited, and an approximate rectangle is preferred, and a rectangular shape, and a rectangular shape with rounded corners (a rectangle having rounded corners) are more preferred, and a rectangular shape is further preferred. When the slit discharge port is an approximate rectangle in shape, the width in the shorter side direction of the rectangle is preferably 0.01 to 10 mm, and more preferably 0.01 to 1.0 mm. The width of the longitudinal direction of the l rectangle usually falls within the range of 10 to 1500 mm.

As the coating solution of the present invention, a coating solution for capillary coating is preferred. The term coating solution for capillary coating used herein means a coating solution for use in coating by a capillary coat method. The capillary coating method refers to a method of applying a coating solution to a bottom face of a substrate while discharging the coating solution toward the bottom face of the substrate from an upwardly-directed nozzle, wherein the coating solution is made to adsorb to the bottom face of the substrate utilizing a capillary phenomenon.

### <Organic compound>

The organic compound contained in the coating solution of the present invention is an organic compound that is a solid at 20°C. When the coating solution is used for production of an organic EL device, examples of the organic compound include an organic luminescent material, an organic hole transport material, an organic hole injection material, an organic electron block material, an organic electron transport material, an organic electron injection material, an organic hole block material and the like. Among these materials, an organic luminescent material is an essential material for an organic EL device, and producing a thin film containing an organic luminescent material using the coating solution of the present invention is preferred in view of production cost.

As an organic luminescent material, a material emitting fluorescence, a material emitting phosphorescence and so on are recited. Materials emitting fluorescence include polymer fluorescent materials and small molecular fluorescent materials. Materials emitting phosphorescence include a polymer compound having a group containing a metal complex in its main chain, side chain or terminal and metal complexes.

### <Polymer fluorescent material>

As a polymer fluorescent material, polymer compounds having a polystyrene-equivalent weight average molecular weight of 1 × 10³ to 1 × 10⁸, and having an arylene group, a divalent heterocyclic group, a divalent aromatic amine group or the like as a repeating unit can be generally recited. The repeating unit possessed by a polymer fluorescent material may be one kind or two or more kinds. Concrete examples of polymer fluorescent materials include polyphenylene, a polymer compound having a naphthalenediyl group as a repeating unit, a polymer compound having an anthracenediyl group as a repeating unit, a polymer compound having a pyrenediyl group as a repeating unit, a polymer compound having a fluorenediyl group as a repeating unit, a polymer compound having a benzofluorenediyl group as a repeating unit, a polymer compound having a thiophenediyl group as a repeating unit, a polymer compound having a dibenzothiophenediyl group as a repeating unit, a polymer compound having a dibenzofurandiyl group as a repeating unit, and a polymer compound having a carbazolediyl group as a repeating unit.

### <Small molecular fluorescent material>

As a small molecular fluorescent material, a naphthalene derivative, anthracene or a derivative thereof, perylene or a derivative thereof, a pigment such as a polymethine-based, xanthene-based, coumarin-based, or cyanine-based pigment, a metal complex of 8-hydroxyquinoline or a derivative thereof, an aromatic amine, tetraphenylcyclopentadiene or a derivative thereof, or tetraphenylbutadiene or a derivative thereof can be recited.

### <Compound emitting phosphorescence>

As a compound emitting phosphorescence, a metal complex such as an iridium complex, a platinum complex, a tungsten complex, a europium complex, a gold complex, an osmium complex, or a rhenium complex, or a polymer compound having a group containing such a metal complex in its main chain, side chain or terminal can be recited.

When a thin film containing an organic luminescent material is produced using a coating solution of the present invention, it is preferred that the coating solution contains a polymer fluorescent material or a polymer compound having a group containing a metal complex in its main chain, side chain or terminal from the viewpoint of viscosity of the coating solution.

### <Solvent>

The boiling point of the first solvent contained in the coating solution of the present invention is lower than 170°C, and from the viewpoint of storage stability, the boiling point is preferably 35°C or higher, and more preferably 100°C or higher.

The boiling point of the second solvent contained in the coating solution of the present invention is 170°C or higher, and is preferably 180°C or higher from the viewpoint of reducing clogging of the slit. From the viewpoint of the process of volatilizing the solvent, the boiling point is preferably 300°C or lower, and more preferably 280°C or lower, and further preferably 250°C or lower.

As a solvent contained in the coating solution of the present invention, the following solvents can be recited. As the first solvent, those having a boiling point of lower than 170°C among the following solvents are exemplified, while as the second solvent, those having a boiling point of 170°C or higher among the following solvents are exemplified.

Aliphatic chloride solvents such as chloroform (boiling point (hereinafter, b.p.) 61°C), methylene chloride (b.p. 40°C), 1,1-dichloroethane (b.p. 57°C), 1,2-dichloroethane (b.p. 83°C), 1,1,1-trichloroethane (b.p. 74°C), and 1,1,2-trichloroethane (b.p. 113°C), aromatic chloride solvents such as chlorobenzene (b.p. 132°C), o-dichlorobenzene (b.p. 180°C), m-dichlorobenzene (b.p. 173°C), and p-dichlorobenzene (b.p. 174°C), aliphatic ether solvents such as tetrahydrofuran (b.p. 66°C), and 1,4-dioxane (b.p. 101°C), aromatic ether solvents such as anisole (b.p. 154°C), and ethoxybenzene (b.p. 170°C), aromatic hydrocarbon solvents such as toluene (b.p. 111°C), o-xylene (b.p. 144°C), m-xylene (b.p. 139°C), p-xylene (b.p. 138°C), ethylbenzene (b.p. 136°C), p-diethylbenzene (b.p. 184°C), mesitylene (b.p. 211°C), n-propylbenzene (b.p. 159°C), isopropylbenzene (b.p. 152°C), n-butylbenzene (b.p. 183°C), isobutylbenzene (b.p. 173°C), s-butylbenzene (b.p. 173°C), tetralin (b.p. 208°C), and cyclohexylbenzene (b.p. 235°C: measured at 737 mmHg), aliphatic hydrocarbon solvents such as cyclohexane (b.p. 81°C), methylcyclohexane (b.p. 101°C), n-pentane (b.p. 36°C), n-hexane (b.p. 69°C), n-heptane (b.p. 98°C), n-octane (b.p. 126°C), n-nonane (b.p. 151°C), n-decane (b.p. 174°C), decaline (b.p 196°C for cis isomer, b.p. 187°C for trans isomer), and bycylohexyl (b.p. 217 to 233°C), aliphatic ketone solvents such as acetone (b.p. 56°C), methylethylketone (b.p. 80°C), methylisobutylketone (b.p. 117°C), cyclohexanone (b.p. 156°C), 2-heptanone (b.p. 150°C), 3-heptanone (b.p. 147°C: measured at 765 mmHg), 4-heptanone (b.p. 144°C), 2-octanone (b.p. 174°C), 2-nonanone (b.p. 195°C), and 2-decanone (b.p. 209°C), aromatic ketone solvents such as acetophenone (b.p. 202°C), aliphatic ester solvents such as ethyl acetate (b.p. 77°C), and butyl acetate (b.p. 120 to 125°C), aromatic ester-based solvents such as methyl benzoate (b.p. 200°C), butyl benzoate (b.p. 213°C), and phenyl acetate (b.p. 196°C), aliphatic polyhydric alcohol solvents and solvents composed of derivatives of aliphatic polyhydric alcohols such as ethyleneglycol (b.p. 198°C), ethyleneglycol monobutyl ether (b.p. 171°C), ethyleneglycol monoethyl ether (b.p. 135°C), ethyleneglycol monomethylether (b.p. 125°C), 1,2-dimethoxyethane (b.p. 85°C), propyleneglycol (b.p. 188°C), 1,2-diethoxymethane (b.p. 124°C), triethyleneglycol diethylether (b.p. 222°C), and 2,5-hexanediol (b.p. 218°C), aliphatic alcohol-based solvents such as methanol (b.p. 65°C), ethanol (b.p. 78°C), propanol (b.p. 97°C), isopropanol (b.p. 82°C), and cyclohexanol (b.p. 161°C), aliphatic sulfoxide-based solvents such as dimethylsulfoxide (b.p. 37°C), aliphatic amide-based solvents such as N-methyl-2-pyrrolidone (b.p. 202°C), and N,N-dimethylformamide (b.p. 153°C) are exemplified.

As a solvent contained in the coating solution of the present invention, aromatic hydrocarbon solvents, aliphatic hydrocarbon solvents, aromatic ester solvents, aliphatic ester solvents, aromatic ketone solvents, aliphatic ketone-based solvents, aromatic ether solvents, and aliphatic ether solvents are preferred from the viewpoints of solubility of the organic compound, flatness of the thin film, viscosity characteristics and the like. As the first solvent, an aromatic compound selected from the group consisting of aromatic hydrocarbon solvents, aromatic ester solvents, aromatic ketone solvents and aromatic ether solvents is preferred from the viewpoint of flatness of the thin film, and toluene, xylene, ethylbenzene, isopropylbenzene, anisole, and mesitylene are preferred, and xylene, anisole, and mesitylene are more preferred. As the second solvent, an aromatic compound selected from the group consisting of aromatic hydrocarbon solvents, aromatic ester solvents, aromatic ketone solvents and aromatic ether solvents is preferred from the viewpoint of flatness of the thin film, and n-butylbenzene, isobutylbenzene, cyclohexylbenzene and tetralin are preferred, and cyclohexylbenzene and tetralin are more preferred. As a combination of the first solvent and the second solvent, the case where the first solvent is xylene and the second solvent is cyclohexylbenzene, the case where the first solvent is xylene and the second solvent is tetralin, the case where the first solvent is anisole and the second solvent is cyclohexylbenzene, the case where the first solvent is anisole and the second solvent is tetralin, the case where the first solvent is mesitylene and the second solvent is cyclohexylbenzene, and the case where the first solvent is mesitylene and the second solvent is tetralin are preferred.

From the viewpoint of viscosity of the coating solution, it is preferred that both the first solvent and the second solvent are solvents capable of dissolving 1% by weight or more of an organic compound at 60°C, and that at least one of the first solvent and the second solvent is a solvent capable of dissolving 1% by weight or more of an organic compound at 25°C.

The weight of the second solvent contained in the coating solution of the present invention is preferably 0.5 to 99% by weight, and more preferably 5 to 90% by weight, relative to the total weight of the coating solution, from the viewpoints of reducing clogging of the slit and flatness of the thin film.

In the present invention, flatness of the thin film is evaluated in a region distanced 5 mm or farther from the region coated with the coating solution discharged from an end in the longitudinal direction of the slit discharge port except for the part formed at the beginning of coating and the part formed at the end of coating.

In the film formed by application of the coating solution of the present invention, the film thickness of the region coated with the coating solution discharged from an end in the longitudinal direction of the slit discharge port except for the part formed at the beginning of coating and the part formed at the end of coating (hereinafter, also referred to a "film thickness of edge part") can largely vary. In the case of a coating film obtained by application of a coating solution containing an organic luminescent material, since the difference in film thickness will result in uneven brightness, it is preferred to reduce the difference in film thickness and the region where the difference in film thickness arises. From the viewpoint of reducing the difference in film thickness and the region where the difference in film thickness arises, the weight of the second solvent contained in the coating solution of the present invention is preferably 0.5 to 30% by weight, relative to the total weight of the coating solution.

The weight of the first solvent contained in the coating solution of the present invention is preferably 500 to 50000 parts by weight, and more preferably 1000 to 100000 parts by weight, relative to the weight of the organic compound that is solid at 20°C contained in the coating solution, which is defined as 100 parts by weight.

The weight of the second solvent contained in the coating solution of the present invention is preferably 500 to 50000 parts by weight, and more preferably 1000 to 100000 parts by weight, relative to the weight of the organic compound contained in the coating solution, which is defined as 100 parts by weight.

The viscosity of the coating solution of the present invention is preferably 15 to 20 mPa·s, and more preferably 2 to 15 mPa·s from the viewpoint of preventing peeling of the coating solution from the substrate during the coating.

The surface tension of the coating solution of the present invention is preferably 10 to 70 mN/m, and more preferably 20 to 50 mN/m from the viewpoint of flatness of the thin film.

The weight of the organic compound contained in the coating solution of the present invention is preferably 0.01 to 10% by weight, and more preferably 0.1 to 5% by weight, relative to the total weight of the coating solution. When it is less than 0.01% by weight, the coating amount for obtaining the film thickness can increase, and when it is more than 10% by weight, the viscosity can increase.

The vapor pressure of the coating solution of the present invention is preferably 0.001 to 50 mmHg and more preferably 0.005 to 50 mmHg at 25°C from the viewpoint of preventing adhesion of solids at the slit and removing the solvent after coating.

In production of a thin film containing an organic luminescent material using the coating solution of the present invention, the coating solution may contain additives such as a hole transport material, an electron transport material, an inorganic luminescent material and a stabilizer in addition to the organic luminescent material. As such additives, a polymer compound (thickener) of high molecular weight or a poor solvent for increasing the viscosity, a compound of low molecular weight for decreasing the viscosity, and a surfactant for decreasing the surface tension may be used in an appropriate combination. As the polymer compound of high molecular weight, those soluble in the same solvent as that of the high molecular fluorescent material of the present invention, and not inhibiting luminescence or charge transport are recited. For example, polystyrene and polymethylmethacrylate each having a high molecular weight, or the one having a high molecular weight among the high molecular fluorescent materials of the present invention may be used. The polystyrene- equivalent weight average molecular weight is preferably 500,000 or more, and more preferably 1, 000, 000 or more. The coating solution of the present invention may contain an antioxidant for improving the storage stability. As an antioxidant, those soluble in the same solvent as that of the high molecular fluorescent material, and not inhibiting luminescence or charge transport such as phenol-based antioxidants and phosphorus-based antioxidants are recited.

### <Organic EL device>

Next, an organic EL device of the present invention will be described.

The organic EL device of the present invention is an organic EL device produced by a production method including the step of coating a substrate with the coating solution of the present invention by an application method comprising discharging a coating solution through a slit discharge port. The organic EL device of the present invention is structured to have a luminescent layer between electrodes made up of a pair of an anode and a cathode at least one of which is transparent or translucent, in particular, it is preferred that an organic compound is contained in the luminescent layer is preferred, and it is more preferred that the organic luminescent material (a small molecular fluorescent material, a polymer fluorescent material, or a compound emitting phosphorescence) is contained in the luminescent layer.

In the organic EL device, as a layer other than the cathode, the anode, and the luminescent layer, a layer provided between the cathode and the luminescent layer, and a layer provided between the anode and the luminescent layer can be recited. As a layer provided between the cathode and the luminescent layer, an electron injection layer, an electron transport layer, a hole block layer and the like are recited. For example, when only one layer is provided between the cathode and the luminescent layer, it is an electron injection layer, and when two or more layers are provided between the cathode and the luminescent layer, the layer contacting the cathode is an electron injection layer, and the remainder is called an electron transport layer.

The electron injection layer is a layer having a function of improving electron injection efficiency from the cathode, and the electron transport layer is a layer having a function of improving electron injection from the electron injection layer or the electron transport layer which is closer to the cathode.

When the electron injection layer, or the electron transport layer has a function of blocking transport of holes, such a layer is also referred to a hole block layer. Having a function of blocking transport of holes can be ascertained by fabricating a device that allows flow of only a hole current, and examining the blocking effect according to a reduction in the current value.

As a layer provided between the anode and the luminescent layer, a hole injection layer, a hole transport layer, an electron block layer and the like are recited. When only one layer is provided between the anode and the luminescent layer, it is a hole injection layer, and when two ore more layers are provided between the anode and the luminescent layer, the layer contacting the anode is a hole injection layer, and the remainder is called a hole transport layer. The hole injection layer is a layer having a function of improving hole injection efficiency from the cathode, and the hole transport layer is a layer having a function of improving hole injection from the hole injection layer or the hole transport layer which is closer to the anode. When the hole injection layer or the hole transport layer has a function of blocking transport of electrons, such a layer is also referred to as an electron block layer. Having a function of blocking transport of electrons can be ascertained by fabricating a device that allows flow of only an electron current, and examining the blocking effect according to a reduction in the current value.

As examples of the structure of an organic EL device of the present invention, the following structures a) to d) can be recited.
a) anode/luminescent layer/cathode
b) anode/hole transport layer/luminescent layer/cathode
c) anode/luminescent layer/electron transport layer/cathode
d) anode/hole transport layer/luminescent layer/electron transport layer/cathode
(In the above structures, "/" means that the layers are stacked in contact with each other. Same as above.)

Here, the luminescent layer is a layer having a luminescent function, the hole transport layer is a layer having a function of transporting holes, and the electron transport layer is a layer having a function of transporting electrons. The electron transport layer and the hole transport layer are collectively called "charge transport layers". For each of the luminescent layer, the hole transport layer, and the electron transport layer, two or more layers may be used independently.

Among the charge transport layers provided in contact with an electrode, the one having a function of improving charge injection efficiency from the electrode and having an effect of lowering drive voltage of the device is also specifically called a charge injection layer (a hole injection layer, an electron injection layer) in general.

Further, for improving adhesion with an electrode or improving charge injection from an electrode, the charge injection layer or an insulation layer having a film thickness of 2 nm or less may be provided in contact with an electrode, and for improving adhesion at the interface, or for preventing mixing, a thin buffer layer may be inserted into the interface of the charge transport layer or the luminescent layer. The order and the number of layers to be stacked, and the thickness of each layer may be appropriately selected in consideration of luminous efficiency and device life time.

In the present invention, as an organic EL device provided with a charge injection layer (an electron injection layer, a hole injection layer), an organic EL device wherein a charge injection layer is provided in contact with a cathode, and an organic EL device wherein a charge injection layer is provide in contact with an anode are recited. For example, concretely, the following structures e) to p) are recited.
e) anode/charge injection layer/luminescent layer/cathode
f) anode/luminescent layer/charge injection layer/cathode
g) anode/charge injection layer/luminescent layer/charge injection layer/cathode
h) anode/charge injection layer/hole transport layer /luminescent layer/cathode
i) anode/hole transport layer /luminescent layer/charge injection layer/cathode
j) anode/charge injection layer/hole transport layer /luminescent layer/charge injection layer/cathode
k) anode/charge injection layer/luminescent layer/charge transport layer/cathode
l) anode/luminescent layer/electron transport layer/charge injection layer/cathode
m) anode/charge injection layer/luminescent layer/electron transport layer/charge injection layer/cathode
n) anode/charge injection layer/hole transport layer /luminescent layer/charge transport layer/cathode
o) anode/hole transport layer /luminescent layer/electron transport layer/charge injection layer/cathode
p) anode/charge injection layer/hole transport layer /luminescent layer/electron transport layer/charge injection layer/cathode

### <Production method of organic EL device>

A thin film formed by a coating method comprising applying a coating solution by an application method comprising discharging a coating solution through a slit discharge port using the coating solution of the present invention has sufficiently high flatness, and thus is suitably used for production of a thin film possessed by an organic EL device. The coating solution also has an effect of reducing clogging of the slit, and enables repetitive coating operations.

A production method of an organic EL device of the present invention is a method for producing an organic EL device including the step of applying a coating solution of the present invention by an application method comprising discharging a coating solution through a slit discharge port.

By the step of applying a coating solution of the present invention by an application method in comprising discharging a coating solution through a slit discharge port, a thin film possessed by the organic EL device is produced. The thin film may be used for a luminescent layer, a hole transport layer , a hole injection layer, an electron block layer, an electron transport layer, an electron injection layer, a hole block layer and the like.

A production process of an organic EL device may include the step of applying the coating solution of the present invention by an application method comprising discharging a coating solution through a slit discharge portto form a first thin film, and the step of applying a coating solution to the first thin film by an application method comprising discharging a coating solution through a slit discharge port to form a second thin film. The coating solution used in formation of the first thin film and the coating solution used in formation of the second thin film may be the same or different, however, they are preferably different from each other from the viewpoint of improving device characteristics of the organic EL device.

As a combination of the first thin film and the second film, a combination wherein the first thin film is a hole injection layer and the second thin film is a luminescent layer, a combination wherein the first thin film is a hole transport layer and the second thin film is a luminescent layer, a combination wherein the first thin film is an electron block layer and the second thin film is a luminescent layer, a combination wherein the first thin film is a hole injection layer and the second thin film is a hole transport layer, and a combination wherein the first thin film is a luminescent layer and the second thin film is an electron transport layer can be recited.

Between the step of applying a coating solution of the present invention by an application method comprising discharging a coating solution through a slit discharge port to form a first thin film, and the step of applying a coating solution to the first thin film by an application method comprising discharging a coating solution is through a slit discharge port to form a second thin film, treatments such as heating and UV irradiation may be conducted on the first thin film. Another thin film may be formed on the second thin film.

### Examples

In the following, examples for specifically describing the present invention will be shown.

### <Measurement method of viscosity>

The viscosity of a coating solution was measured at 20°C by LV DV-II+Pro CP (available from BROOKFIELD).

### <Measurement method of surface tension>

The surface tension of a coating solution was measured at 20°C by OCA20 (available from EKO INSTRUMENTS CO., LTD.).

### <Glass substrate>

A glass substrate of 1713 glass having a dimension of 190 mm × 190 mm (available from Corning Incorporated) was washed by a SPBC-200M spin washer (available from Micro Engineering Inc.) before use. Immediately before coating, the glass substrate was UV-washed by using Model 208 UV-03 Cleaning System (available from TCHNOVISON).

### <Coating method>

As a coating apparatus for a capillary coat method, CAP Coater III (available from HIRANO TECSEED CO., Ltd.) was used. A discharge port of this coating apparatus was rectangular, and the length of the long side was 240 mm and the length of the short side was 0.3 mm.

### <Evaluation method of flatness of thin film>

The flatness of a film formed by application onto a glass substrate followed by drying for 5 minutes under a reduced pressure of 1 × 10⁻² Pa or less was observed by alpha-step 250 (available from TENCOR INSTRUMENTS). In the alpha-step, measurement was conducted for arbitrary three points in a width of 200 µm excluding the part formed at the beginning of application and the part formed at the end of application, and the region where the coating solution discharged from the end in the longitudinal direction of the slit discharge port was applied, and evaluation was made by the center-line average roughness Ra and the maximum irregularity height. The center-line average roughness Ra is a value obtained by folding back a roughness curve at the center line, and dividing an area obtained by the roughness curve and the center line by the measured width.

### <Evaluation method of number of times of continuous coating operations of thin film>

As to the frequency of clogging of the nozzle, a series of operations of placing a substrate on a sample stage, coating the substrate with a coating solution for capillary coating, changing the substrate, and coating the substrate with a coating solution for capillary coating were repeated ten times, and how many times normal coating was achieved was determined.

### <Measurement method of film thickness of region coated with coating solution discharged from end of longitudinal direction of slit discharge port>

The film thickness of the edge part was measured using a stylus film thickness meter P-16+ available from TENCOR.

### <Example 1>

To 1 g of an organic luminescent material Lumation GP1300 (Green 1300) (available from Sumation Co., Ltd.), 50 g of anisole (b.p. 154°C) and 50 g of cyclohexylbenzene (b.p. 235 to 236°C) were added, and thus a coating solution for capillary coating 1 was prepared. The weight of the organic luminescent material was 1.0% by weight, relative to the total weight of the coating solution for capillary coating. The viscosity of the coating solution for capillary coating 1 was 6.3 mPa·s, and the surface tension was 32.1 mN/m. Coating a substrate with the coating solution for capillary coating 1 was executed under the conditions: a coating speed of 0.3 m/min, a liquid level of 10 mm, and a coating gap of 220 µm. As a result of evaluation of the number of times of continuous coating operations, coating was successful up to the tenth operation without problems. The results of evaluation about flatness of the film after film formation are shown in Table 1. When the coating solution for capillary coating 1 was used, both coating characteristics and flatness of the film after film formation sufficiently satisfied the practical levels.

### <Comparative example 1>

To 1 g of an organic luminescent material Lumation GP1300 (Green 1300) (available from Sumation Co., Ltd.), 100 g of toluene (b.p. 111°C) was added, and thus a coating solution for capillary coating 2 was prepared. The weight of the organic luminescent material was 1.0% by weight, relative to the total weight of the coating solution for capillary coating. The viscosity of the coating solution for capillary coating 2 was 2.5 mPa·s, and the surface tension was 26.4 mN/m. As a result evaluation of number of times of continuous coating operations, clogging occurred in the nozzle in the first coating, and streaky coating nonuniformity arose in the coating direction. Second and later coating operations could not be completed because of clogging of the nozzle. The results of evaluation about flatness of the film after film formation are shown in Table 2. When the coating solution for capillary coating 2 was used, coating nonuniformity arose due to clogging caused by growth of the solute in the first coating, and flatness of the film after film formation was poor, and the practical levels were not achieved.

**Table 1**

| Site of measurement | Ra value (Å) | Maximum irregularity height (Å) |
|---|---|---|
| 1 | 27 | 81 |
| 2 | 25 | 46 |
| 3 | 27 | 105 |

**Table 2**

| Site of measurement | Ra value (Å) | Maximum irregularity height (Å) |
|---|---|---|
| 1 | 82 | 420 |
| 2 | 88 | 431 |
| 3 | 73 | 320 |

### <Example 2>

In a mixed solvent of 80 g of xylene and 20 g of cyclohexylbenzene (xylene:cyclohexylbenzene = 8:2 (weight ratio)), 1 g of an organic luminescent material Lumation GP1300 (Green 1300) (available from Sumation Co., Ltd.) was dissolved, to prepare a coating solution for capillary coating 3. The viscosity of the coating solution for capillary coating 3 was 10.3mPa·s. Coating a substrate with the coating solution for capillary coating 3 was executed so that the film thickness after drying was about 100 nm under the conditions: a coating speed of 1.5 m/min, a liquid level of 15 mm, and a coating gap of 200 µm. When the coating solution for capillary coating 3 was used, both coating characteristics and flatness of the film after film formation sufficiently satisfied the practical levels.

### <Example 3>

In a mixed solvent of 50 g of xylene and 50 g of cyclohexylbenzene (xylene:cyclohexylbenzene = 5:5 (weight ratio)), 1 g of an organic luminescent material Lumation GP1300 (Green 1300) (available from Sumation Co., Ltd.) was dissolved, to prepare a coating solution for capillary coating 4. The viscosity of the coating solution for capillary coating 4 was 9.0 mPa·s. Coating a substrate with the coating solution for capillary coating 4 was executed so that the film thickness after drying was about 100 nm under the conditions: a coating speed of 1.5 m/min, a liquid level of 15 mm, and a coating gap of 200 µm. When the coating solution for capillary coating 4 was used, both coating characteristics and flatness of the film after film formation sufficiently satisfied the practical levels.

### <Evaluation of width with variable film thickness of edge part>

The film thickness distribution of a thin film formed by using the coating solution for capillary coating 3 and of a thin film formed by using the coating solution for capillary coating 4 are shown in Fig. 1. While the region where the film thickness of the edge part varies in the thin film formed by using the coating solution for capillary coating 4 wherein the weight of cyclohexylbenzene is 50% by weight relative to the total weight of the coating solution is 5 mm, the region where the film thickness of the edge part varies in the thin film formed by using the coating solution for capillary coating 3 wherein the weight of cyclohexylbenzene is 20% by weight relative to the total weight of the coating solution is 2.5 mm or less, revealing that the thin film formed by using the coating solution for capillary coating 3 has a smaller region where the film thickness of the region coated with the coating solution discharged from the end of the longitudinal direction of the slit discharge port varies.

### Industrial Applicability

By forming a thin film using a coating solution of the present invention for an application method in which a coating solution is discharged through a slit discharge port, by the application method, it is possible to make flatness of the thin film sufficiently high. The coating solution of the present invention is useful for production of an organic electroluminescence device or the like, and is industrially very useful.

## Claims

1. A coating solution for an application method comprising discharging a coating solution through a slit discharge port, the coating solution comprising an organic compound that is a solid at 20°C, a first solvent having a boiling point of lower than 170°C, and a second solvent having a boiling point of 170°C or higher.

2. The coating solution according to claim 1, wherein the slit discharge port is an approximate rectangle in shape, and the width in the shorter side direction of the approximate rectangle is 0.01 to 10 mm.

3. The coating solution according to claim 1 or 2 which is a coating solution for capillary coating.

4. The coating solution according to any one of claims 1 to 3, wherein the organic compound is an organic compound for use in an organic electroluminescence device.

5. The coating solution according to any one of claims 1 to 4, wherein the weight of the second solvent is 0.5 to 99% by weight relative to the total weight of the coating solution.

6. The coating solution according to claim 5, wherein the weight of the second solvent is 0.5 to 30% by weight relative to the total weight of the coating solution.

7. The coating solution according to any one of claims 1 to 6, wherein the first solvent is an aromatic compound.

8. The coating solution according to claim 7, wherein the first solvent is xylene, anisole or mesitylene.

9. The coating solution according to any one of claims 1 to 8, wherein the second solvent is an aromatic compound.

10. The coating solution according to claim 9, wherein the second solvent is cyclohexylbenzene or tetralin.

11. The coating solution according to any one of claims 1 to 10, wherein the weight of the organic compound is 0.01 to 10% by weight relative to the total weight of the coating solution.

12. The coating solution according to any one of claims 1 to 11 having a viscosity of 1 to 20 mPa·s.

13. The coating solution according to any one of claims 1 to 12 having a surface tension of 10 to 70 mN/m.

14. A coating method comprising applying the coating solution according to any one of claims 1 to 13 by an application method comprising discharging the coating solution through a slit discharge port.

15. A method for producing an organic electroluminescence device ,the method comprising the step of applying the coating solution according to any one of claims 1 to 13 by an application method comprising discharging the coating solution through a slit discharge port.

16. A method for producing an organic electroluminescence device, the method comprising the steps of:
applying the coating solution according to any one of claims 1 to 13 by an application method comprising discharging the coating solution through a slit discharge port to form a first thin film, and
applying a coating solution to the first thin film by an application method comprising discharging the coating solution through a slit discharge port to form a second thin film.

17. The production method according to claim 16, wherein the coating solution to be used in the step of forming the first thin film and the coating solution to be used in the step of forming the second thin film are different from each other.

18. An organic electroluminescence device produced by the production method according to any of claims 15 to 17.
